Europäisches Patentamt

European Patent Office

Office européen des brevets

(11) Veröffentlichungsnummer: **0 477 606 A1**

# EUROPÄISCHE PATENTANMELDUNG

(21) Anmeldenummer: **91114863.3**

(51) Int. Cl.5: **H05K 13/02**

(22) Anmeldetag: **03.09.91**

(30) Priorität: **28.09.90 DE 4030786**

(43) Veröffentlichungstag der Anmeldung:
**01.04.92 Patentblatt 92/14**

(84) Benannte Vertragsstaaten:
**AT BE CH DE ES FR GB IT LI NL SE**

(71) Anmelder: **SIEMENS AKTIENGESELLSCHAFT**
**Wittelsbacherplatz 2**

**W-8000 München 2(DE)**

Erfinder: **Grasmüller, Horst, Ing. (grad.)**
**Kapellenstrasse 4**
**W-8083 Mammendorf(DE)**
Erfinder: **Schuster, Rudolf, Dipl.-Ing.**
**Graf-Andechs-Strasse 8**
**W-8011 Kirchheim(DE)**

(54) **Saugpipette zum Aufnehmen, Transportieren und Posizionieren von Bauelementen.**

(57) Bei der Bestückung von Leiterplatten mit elektronischen Bauelementen werden die Bauelemente (B) mit Saugpipetten (S) oder daran angebrachten Adaptern (Ad1) aus Zuführeinrichtungen entnommen und dann auf der Leiterplatte positioniert. Sind die Bauelemente (B) in den Zuführeinrichtungen nicht parallel zur Saugfläche ausgerichtet, so wird Falschluft gesaugt und eine Entnahme verhindert. Eine flexible Anpassung an die Schräglage eines Bauelements (B) beim Abholen und an die horizontale Lage der Bestückoberfläche (Bo) beim Positionieren wird durch eine äußere elastische Dichtlippe (D1) zum Ansaugen der Bauelemente (B) und einem inneren starren Anschlag (A1) für die angesaugten Bauelemente (B) erreicht, wobei die Dichtlippe (D1) in axialer Richtung über den Anschlag (A1) hinausragt.

FIG 2

EP 0 477 606 A1

Es ist bekannt, bei der automatischen Bestük-kung von Leiterplatten mit SMD-Bauelementen verfahrbare Bestückköpfe einzusetzen, die mit einer zentrisch angeordneten Saugpipette ausgerüstet sind. Mit Hilfe dieser an eine Vakuumquelle angeschlossenen Saugpipetten werden die Bauelementen aus Zuführeinrichtungen entnommen, zur Leiterplatte hin transportiert, gegebenenfalls zentriert und in die richtige Einbaulage gedreht und dann in der vorgegebenen Bestückposition auf der Leiterplatte positioniert. Zur Anpassung an unterschiedliche Formen und Größen der Bauelemente werden Saugpipetten mit unterschiedlich bemessenen Saugflächen am unteren Ende benötigt. Dies wird in der Regel durch Adapter unterschiedlicher Größe bewerkstelligt, die auf das untere Ende einer Saugpipette gleichbleibender Größe aufgesetzt werden und vom Bestückkopf automatisch gewechselt werden können. Sind bei der Entnahme von Bauelementen die Zuführeinrichtungen nicht parallel zu der Saugfläche an der Saugpipette oder am Adapter ausgerichtet, so wird Falschluft gesaugt und das Bauelement kann dann häufig nicht aufgenommen werden. Für die Zentrierung der Bauelemente und vor allem für die Positionierung der Bauelemente auf der Leiterplatte ist es aber wichtig, daß das Bauelement parallel zur Bestückoberfläche aufgesetzt wird. Dementsprechend sollen sich also Saugpipette oder Adapter einerseits beim Abholvorgang an die aktuelle Schräglage des Bauelements anpassen und andererseits beim Bestückvorgang das Bauelement parallel zur Bestückoberfläche absetzen. Diesen beiden Forderungen wird dadurch Rechnung getragen, daß für das Abholen der Bauelemente und die Übergabe der Bauelemente an eine Meßstation ein erster weicher Adapter eingesetzt wird und daß dann zwischen Meßstation und Bestückort ein zweiter, harter Adapter eingesetzt wird.

Der im Anspruch 1 angegebenen Erfindung liegt das Problem zugrunde, mit geringem Aufwand eine flexible Anpassung der Saugpipette an die Schräglage eines Bauelements beim Abholvorgang und an die Lage der Bestückoberfläche beim Positionieren des Bauelements zu gewährleisten.

Die mit der Erfindung erzielten Vorteile bestehen insbesondere darin, daß sich die voreilende Dichtlippe beim Abholvorgang einer eventuellen Schräglage des Bauelements elastisch anpaßt. Dadurch wird das Bauelement von der Saugpipette sicher erfaßt und nach der Entnahme aus der Zuführeinrichtung durch die Anlage an dem starren Anschlag in einer horizontalen Lage eindeutig fixiert. Hierbei kann auf das Bauelement ein Ausrichtmoment ausgeübt werden, welches vom Ansaugdruck, von der durch die Dichtlippe bestimmten Ansaugfläche und vom Radius des entsprechenden Anlagepunktes am Anschlag abhängig ist.

Auch bei der Positionierung der Bauelemente auf der Leiterplatte kann durch den starren Anschlag eine Anpassung an eine eventuelle Schräglage der Bestückoberfläche bewirkt werden.

Vorteilhafte Ausgestaltungen der Erfindung sind in den Ansprüchen 2 bis 5 angegeben.

Die Ausgestaltung nach Anspruch 2 betrifft eine besonders einfache Anbringung der Dichtlippe an einen Adapter. Alternativ dazu kann die Dichtlippe gemäß Anspruch 3 aber auch durch den elastischen Endbereich eines Adapters gebildet sein.

Die Ausgestaltung nach Anspruch 4 ermöglicht relativ hohe Ausrichtmomente, die mit dem Radius der punktförmigen oder flächigen Bereiche zunehmen und insbesondere für harte, unempfindliche Bauelemente geeignet sind.

Die Ausgestaltung nach Anspruch 4 ermöglicht demgegenüber für empfindliche Bauelemente sehr kleine Ausrichtmomente. Im Fall eines punktförmigen bzw. spitzigen mittigen Anschlags wird das

Ausrichtmoment ausschließlich durch Wegunterschiede der elastischen Dichtlippe hervorgerufen.

Ausführungsbeispiele der Erfindung im Vergleich zum Stand der Technik sind in der Zeichnung dargestellt und werden im folgenden beschrieben.

Es zeigen

FIG 1 die Aufnahme eines schräg ausgerichteten Bauelements mit einer herkömmlichen Saugpipette,

FIG 2 die Aufnahme eines schräg ausgerichteten Bauelements mit einer ersten Ausführungsform einer erfindungsgemäßen Saugpipette und

FIG 3 eine Draufsicht auf den Anschlag des Adapters der in FIG 2 dargestellten Saugpipette und

FIG 4 die Aufnahme eines schräg ausgerichteten Bauelements mit einer zweiten Ausführungsform einer erfindungsgemäßen Saugpipette.

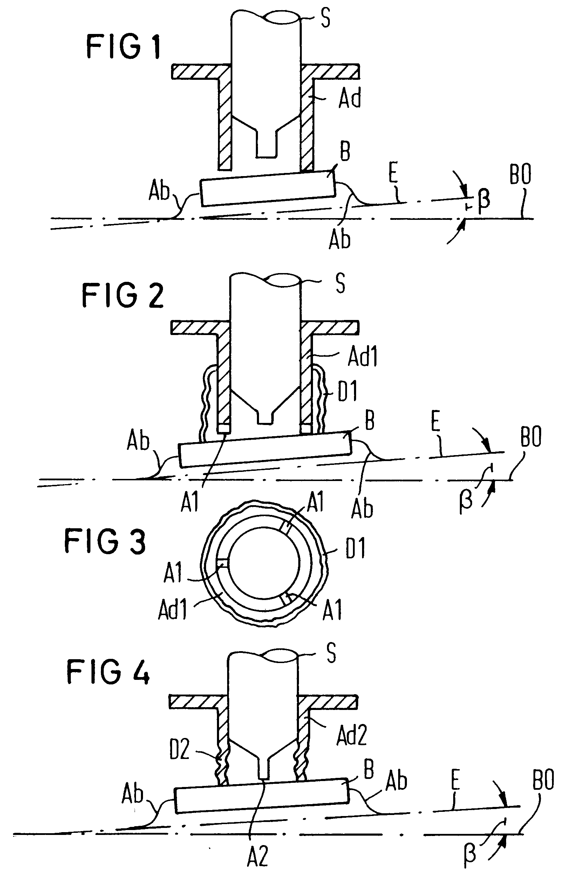

FIG 1 zeigt eine Saugpipette S mit einem an ihrem unteren Ende angebrachten steifen Adapter Ad herkömmlicher Bauart. Mit B ist ein elektronisches Bauelement bezeichnet, das mit seinen Anschlußbeinchen Ab auf der Ebene E einer entsprechenden Zuführeinrichtung aufliegt. Diese Ebene E ist in den schematisch aufgezeigten Fall in Bezug auf die Bestückoberfläche Bo, d.h. die Oberfläche einer mit dem Bauelement B zu bestückenden Leiterplatte, um einen Winkel $\beta$ geneigt. Da die Saugfläche des Adapters A parallel zu der Bestückoberfläche Bo ausgerichtet ist, ergibt sich eine dem Winkel $\beta$ entsprechende Neigung zwischen der Saugfläche und der Ebene E der Zuführeinrichtung. Diese Neigung bewirkt dann aber bei der Entnahme des Bauelements B aus der Zuführeinrichtung daß Falschluft gesaugt wird und daß ab einem gewissen Betrag des Winkels $\beta$ die beabsichtigte Entnahme des Bauelements B aus der Zuführeinrichtung verhindert wird.

FIG 2 zeigt wiederum eine Saugpipette S mit einem an ihrem unteren Ende aufgebrachten steifen Adapter Ad1. Dieser steife Adapter Ad1 ist jedoch zusätzlich noch mit einer elastischen Dichtlippe D1 ausgerüstet, welche den unteren Endbereich des Adapters Ad1 konzentrisch mit Abstand umschließt. Das obere Ende der aus einem weichen, elastischen Material wie z.B. Silikonkautschuk bestehenden Dichtlippe D1 liegt dicht am Außenumfang des Adapters Ad1 an, während das die Ansaugfläche bildende untere Ende der Dichtlippe D1 nach unten über den an der Stirnseite des Adapters Ad1 gebildeten starren Anschlag A1 hinausragt. Wie insbesondere in FIG 3 zu erkennen ist, ist der Anschlag A1 durch drei um 120 Grad versetzt zueinander angeordnete, nach unten vorspringende flächige Bereiche des Adapters Ad1 gebildet. Zwischen diesen flächigen Bereichen kann dann beim Ansaugvorgang die Luft hindurchtreten.

Auch bei dem in FIG 2 aufgezeigten Fall soll mit der Saugpipette S ein Bauelement B aus einer Zuführeinrichtung entnommen werden, deren Ebene E in Bezug auf die Bestückoberfläche Bo um einen Winkel $\beta$ geneigt ist. Es ist ohne weiteres zu erkennen, daß sich die voreilende weiche Dichtlippe D1 elastisch an die Schräglage des Bauelements B anpaßt und dessen Entnahme aus der Zuführeinrichtung mit Sicherheit gewährleistet ist. Durch die Saugwirkung wird das Bauelement B zunächst an einem Punkt des Anschlags A1 anliegen und durch das dann entstehende Ausrichtmoment vollständig an den drei Flächen des Anschlags A1 zur Anlage gebracht. Damit ist das Bauelement B dann in einer horizontalen, parallel zur Bestückoberfläche Bo ausgerichteten Lage eindeutig fixiert.

Bei der in FIG 4 dargestellten Ausführungsform ist die Dichtlippe D2 durch den elastischen Endbereich eines Adapters Ad2 gebildet. Als starrer Anschlag A2 dient hier ein zentral in der Mitte angeordneter Vorsprung der Saugpipette S, mit einer relativ kleinen, kreisförmigen Anschlagfläche. Durch die mittige Lage und durch die geringe Fläche dieses Anschlags A2 wird in diesem Fall durch den Ansaugdruck kein oder allenfalls nur ein geringes Ausrichtmoment bewirkt. Das Ausrichten des Bauelements B wird in diesem Fall nur dadurch erreicht, daß sich die Dichtlippe D2 beim Abholvorgang elastisch verformt und dann wieder zurückfedert. Beim Positionieren kann das Bauelement B um den starren Anschlag A2 gedreht und damit an eine eventuelle Schräglage der Bestückoberfläche Bo angepaßt werden.

**Patentansprüche**

1. Saugpipette zum Aufnehmen, Transportieren und Positionieren von Bauelementen, insbesondere bei der automatischen Bestückung von Leiterplatten, mit
   - einer äußeren, elastischen Dichtlippe (D1; D2) zum Ansaugen der Bauelemente (B) und
   - einem inneren, starren Anschlag (A1; A2) für die von der Dichtlippe (D1; D2) angesaugten Bauelemente (B), wobei
   - die Dichtlippe (D1; D2) in axialer Richtung über den Anschlag (A1; A2) hinausragt.

2. Saugpipette nach Anspruch 1, **dadurch gekennzeichnet**, daß die Dichtlippe (D1) außen an einen Adapter (Ad1) angebracht ist.

3. Saugpipette nach Anspruch 1, **dadurch gekennzeichnet**, daß die Dichtlippe (D2) durch den elastischen Endbereich eines Adpaters (Ad2) gebildet ist.

4. Saugpipette nach Anspruch 1 oder 2, **dadurch gekennzeichnet**, daß der Anschlag (A1) durch mindestens drei in Umfangsrichtung versetzt zueinander angeordnete, punktförmige oder flächige Bereiche gebildet ist.

5. Saugpipette nach Anspruch 1 oder 3, **dadurch gekennzeichnet**, daß der Anschlag (A2) durch einen zentralen, punktförmigen oder flächigen Bereich gebildet ist.

FIG 1

FIG 2

FIG 3

FIG 4

## EUROPÄISCHER RECHERCHENBERICHT

Nummer der Anmeldung

| EINSCHLÄGIGE DOKUMENTE | | | EP 91114863.3 | | |

| Kategorie | Kennzeichnung des Dokuments mit Angabe, soweit erforderlich, der maßgeblichen Teile | Betrifft Anspruch | KLASSIFIKATION DER ANMELDUNG (Int. Cl⁵) |
|---|---|---|---|
| A | <u>DE - A - 3 915 556</u><br>(HITACHI)<br>    * Zusammenfassung; Fig. 1;<br>      Patentansprüche 1-12 *<br>        -- | 1 | H 05 K 13/02 |
| A | <u>EP - A - 0 154 552</u><br>(DYNAPART)<br>    * Zusammenfassung; Fig. 1,2 *<br>        -- | 1 | |
| A | <u>GB - A - 2 034 613</u><br>(TOKYO SHIBAURA DENKI)<br>    * Zusammenfassung; Fig. 1 *<br>        -- | 1 | |
| A | <u>US - A - 4 653 664</u><br>(HINENO)<br>    * Zusammenfassung; Fig. 1 *<br>        ---- | 1 | |

| | RECHERCHIERTE SACHGEBIETE (Int. Cl⁵) |
|---|---|
| | H 05 K 13/00 |

Der vorliegende Recherchenbericht wurde für alle Patentansprüche erstellt.

| Recherchenort | Abschlußdatum der Recherche | Prüfer |
|---|---|---|
| WIEN | 20-12-1991 | VAKIL |